# EUROPEAN PATENT APPLICATION

(11) **EP 4 812 011 A1**
(43) Date of publication of application: **23.09.2026**
(21) Application number: 25224287.0
(22) Date of filing: 17.12.2025
(51) Int. Cl.: H10W 80/00

(54) **MICROELECTRONIC ASSEMBLIES HAVING AIR GAP FIDUCIALS**

(30) Priority: 20.03.2025 US 202519085153
(71) Applicant: INTEL Corporation, Santa Clara, CA 95054 (US)
(72) Inventor: NIAZI, Haris Khan, Brooklyn,NY, 11205 (US); LIFF, Shawna M., Scottsdale, 85255 (US); KRISHNATREYA, Bhaskar Jyoti, Beaverton, 97007 (US)
(74) Representative: 2SPL Patentanwälte PartG mbB

(57) **Abstract**

Microelectronic assemblies, related devices and methods, are disclosed herein. In some embodiments, a microelectronic assembly may include a first microelectronic component having a first bonding layer with a first air gap fiducial; and a second microelectronic component having a second bonding layer with a second air gap fiducial, wherein the first microelectronic component is coupled to the second microelectronic component by the first and second bonding layers, and wherein the first air gap fiducial and the second air gap fiducial are aligned.

## Description

### Background

Integrated circuit (IC) packages typically include multiple components coupled to together and use fiducials for precisely aligning and positioning the components during assembly.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a side, cross-sectional view of an example microelectronic assembly including an air gap fiducial, in accordance with various embodiments.
FIG. 2A is a top view schematic of an example air gap fiducial of a microelectronic assembly, in accordance with various embodiments.
FIG. 2B is a side, cross-sectional view of the example air gap fiducial of FIG. 2A, in accordance with various embodiments.
FIG. 3A is a top view schematic of another example air gap fiducial of a microelectronic assembly, in accordance with various embodiments.
FIG. 3B is a side, cross-sectional view of the example air gap fiducial of FIG. 2A, in accordance with various embodiments.
FIG. 4A is a top view schematic of yet another example air gap fiducial of a microelectronic assembly, in accordance with various embodiments.
FIG. 4B is a side, cross-sectional view of the example air gap fiducial of FIG. 2A, in accordance with various embodiments.
FIG. 5A is a top view schematic of another example air gap fiducial of a microelectronic assembly, in accordance with various embodiments.
FIG. 5B is a top view schematic of another example air gap fiducial of a microelectronic assembly, in accordance with various embodiments.
FIG. 5C is a top view schematic of yet another example air gap fiducial of a microelectronic assembly, in accordance with various embodiments.
FIG. 5D is a top view schematic of a plurality of air gap fiducials arranged in a grid in an example microelectronic assembly, in accordance with various embodiments.
FIG. 6A is a side, cross-sectional view of another example microelectronic assembly including an air gap fiducial, in accordance with various embodiments.
FIG. 6B is a side, cross-sectional view of yet another example microelectronic assembly including an air gap fiducial, in accordance with various embodiments.
FIG. 6C is a side, cross-sectional view of yet another example microelectronic assembly including an air gap fiducial, in accordance with various embodiments.
FIG. 7A is a side, cross-sectional view of example microelectronic components including air gap fiducials, in accordance with various embodiments.
FIG. 7B are top view schematics of respective layers of the microelectronic components of FIG. 7A including air gap fiducials, in accordance with various embodiments.
FIG. 7C is a side, cross-sectional view of an example microelectronic assembly including an air gap fiducial undergoing imaging, in accordance with various embodiments.
FIG. 7D is a schematic image of the air gap fiducial of FIG. 7C, in accordance with various embodiments.
FIG. 8A is a side, cross-sectional view of example microelectronic components including air gap fiducials, in accordance with various embodiments.
FIG. 8B are top view schematics of respective layers of the microelectronic components of FIG. 8A including air gap fiducials, in accordance with various embodiments.
FIG. 8C is a side, cross-sectional view of an example microelectronic assembly including an air gap fiducial undergoing imaging, in accordance with various embodiments.
FIG. 8D is a schematic image of the air gap fiducial of FIG. 8C, in accordance with various embodiments.
FIG. 9A are top view schematics of respective layers of example microelectronic components including air gap fiducials, in accordance with various embodiments.
FIG. 9B is a schematic image of a microelectronic assembly including the air gap fiducial of FIG. 9A, in accordance with various embodiments.
FIGS. 10A-10F are side, cross-sectional views of various stages in an example process for manufacturing a microelectronic component including an air gap fiducial, in accordance with various embodiments.
FIGS. 11A-11F are side, cross-sectional views of various stages in another example process for manufacturing a microelectronic component including an air gap fiducial, in accordance with various embodiments.
FIG. 12A is a schematic top view of an example microelectronic assembly including a capacitive comb structure with an air gap fiducial, in accordance with various embodiments.
FIGS. 12B and 12C are side, cross-sectional views of the example microelectronic assembly of FIG. 12A including a capacitive comb structure with an air gap fiducial, in accordance with various embodiments.
FIGS. 13A-13H are side, cross-sectional views of various stages in an example process for manufacturing a microelectronic component including a capacitive comb structure with an air gap fiducial, in accordance with various embodiments.
FIG. 14 is a top view of a wafer and dies that may be included in a microelectronic assembly, in accordance with any of the embodiments disclosed herein.
FIG. 15 is a cross-sectional side view of an IC device that may be included in a microelectronic assembly, in accordance with any of the embodiments disclosed herein.
FIG. 16 is a cross-sectional side view of an IC device assembly that may include a microelectronic assembly, in accordance with any of the embodiments disclosed herein.
FIG. 17 is a block diagram of an example electrical device that may include a microelectronic assembly, in accordance with any of the embodiments disclosed herein.

### Detailed Description

Coupling two or more components in a multi-die IC package requires precise alignment of the components. Coupling two or more components via direct bonding in a multi-die IC package is even more challenging due to the increasingly small size and thickness of such components, the finer pitch of interconnects, and the reduced thickness of the bonding interface between components (e.g., z-height of die-to-die spacing), among others. Conventional methods for placing and aligning components include mating thick metal fiducials on the bonding interfaces of the respective components. These thick metal fiducials are usually along a perimeter of the components in metal free zones (MFZs) so that an infrared (IR) wavelength metrology tool can be used to interrogate the offset between the respective thick metal fiducials. These thick metal fiducials are limiting in that they require MFZs, which take up valuable design space; they can create floating metal issues, which may interfere with functionality; and they have an accuracy regime of greater than 100 nanometers. As direct bonding pitches approach 1 micron or less, an accuracy regime in the 10s of nanometers is required.

Disclosed herein are air gap fiducials that resolve many of the issues with traditional thick metal fiducials, such as enabling high accuracy overlay at layers where thick metal fiducials cannot be patterned and eliminating the need for MFZs. Air gap fiducials disclosed herein may have a bonding overlay accuracy of approximately 10 nanometers and may be included in front end (FE) layers (e.g., formed at the same time and in compliance with FE layer density rules and polish requirements). Additionally, air gap fiducials may be within an active area of a die (e.g., not along a perimeter) and may include an array of air gap fiducials for characterizing a higher order overlay distortion to achieve a bonding overlay accuracy of less than 10 nanometers. Air gap fiducials may be incorporated with comb capacitors to further serve as capacitive tuning structures or as physical unclonable function for die security in device.

Accordingly, microelectronic assemblies, and related devices and methods, are disclosed herein. For example, in some embodiments, a microelectronic assembly may include a first microelectronic component having a first bonding layer with a first air gap fiducial; and a second microelectronic component having a second bonding layer with a second air gap fiducial, wherein the first microelectronic component is coupled to the second microelectronic component by the first and second bonding layers, and wherein the first air gap fiducial and the second air gap fiducial are aligned. In some embodiments, a microelectronic assembly may include a first microelectronic component having a first surface with a first air gap fiducial in an N-1 layer adjacent to an N layer at the first surface; and a second microelectronic component having a second surface with a second air gap fiducial in an N-1 layer adjacent to an N layer at the second surface, wherein the first microelectronic component is coupled to the second microelectronic component, and wherein the first air gap fiducial and the second air gap fiducial are aligned. In some embodiments, a microelectronic assembly may further include a first portion of a comb capacitor with first fingers in the N layer and in the first air gap fiducial in the N-1 layer of the first microelectronic component; and a second portion of a comb capacitor with second fingers in the N layer and in the second air gap fiducial in the N-1 layer of the second microelectronic component, wherein the first fingers and the second fingers are interdigitated.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

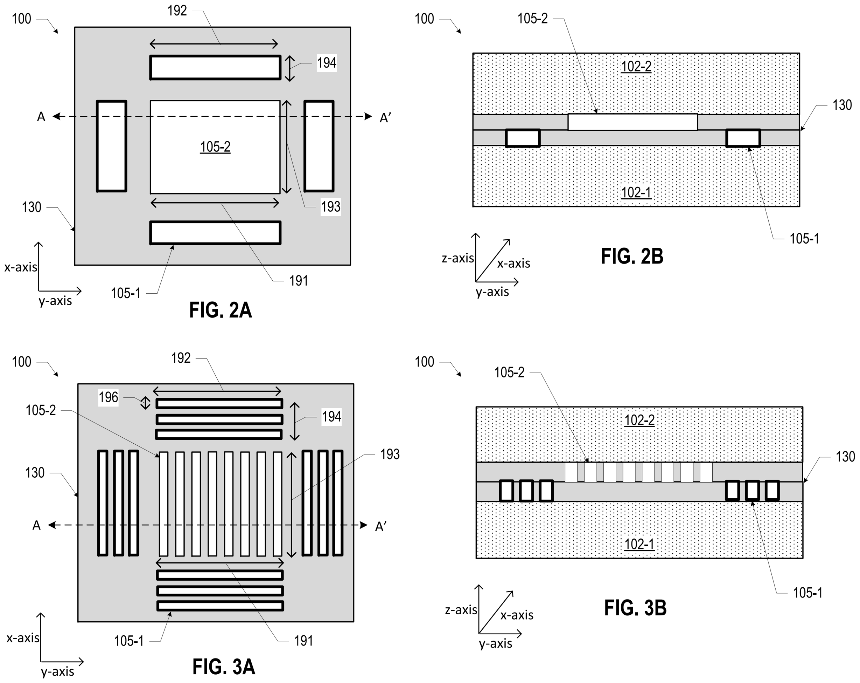

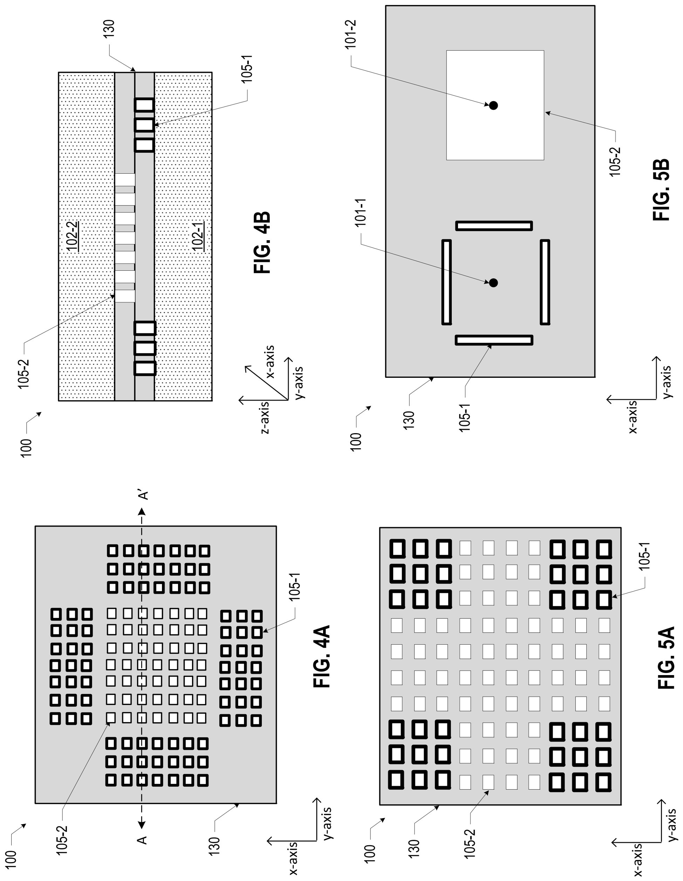

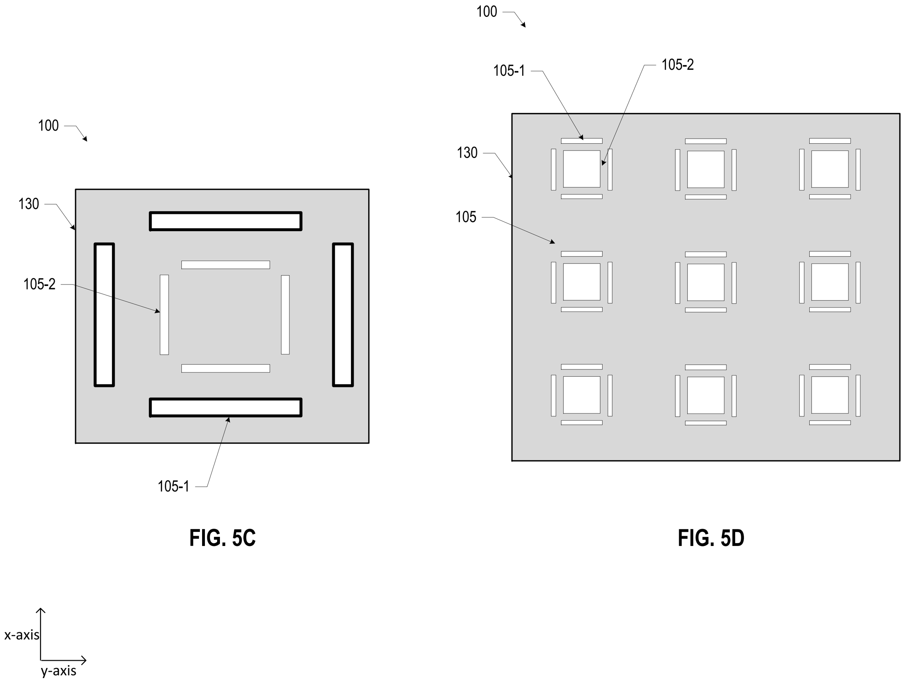

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. When used to describe a range of dimensions, the phrase "between X and Y" represents a range that includes X and Y. The terms "top," "bottom," etc. may be used herein to explain various features of the drawings, but these terms are simply for ease of discussion, and do not imply a desired or required orientation. Although certain elements may be referred to in the singular herein, such elements may include multiple sub-elements. For example, "a dielectric material" may include one or more dielectric materials. For ease of discussion, the drawings of FIGS. 2A and 2B may be referred to herein as "FIG. 2" and the drawings of FIGS. 5A-5C may be referred to herein as "FIG. 5," etc.

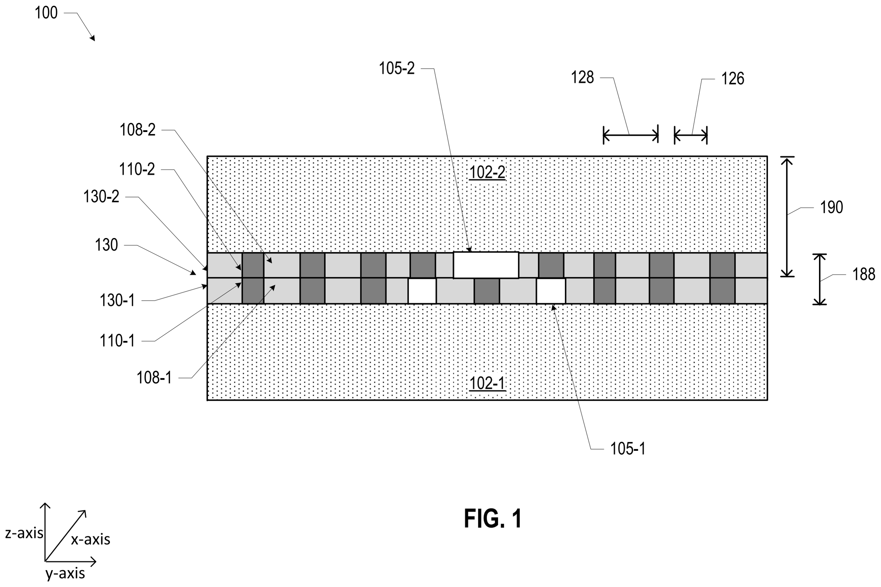

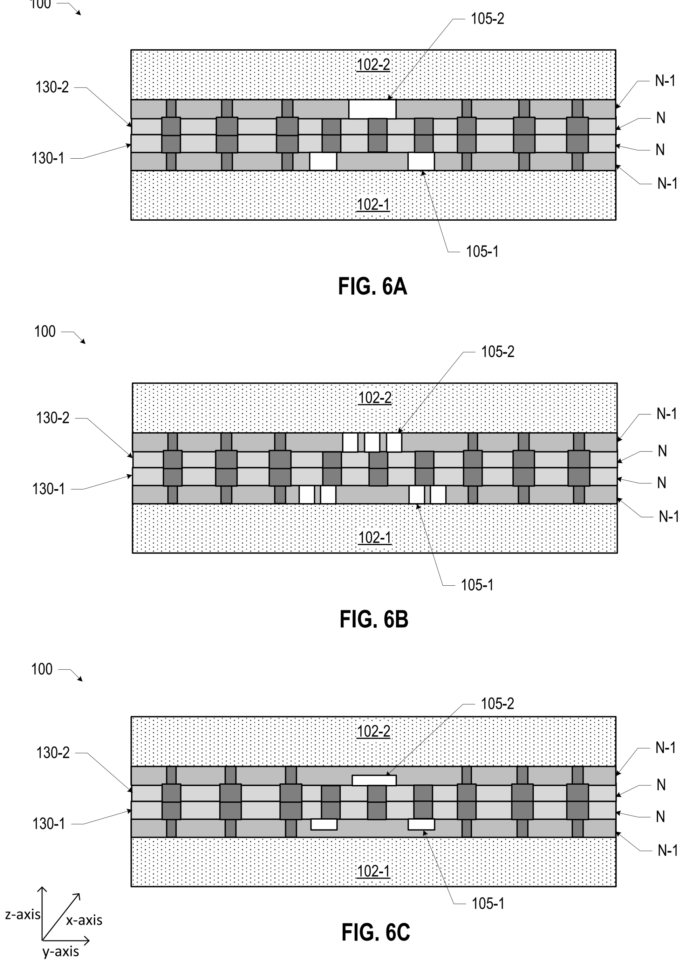

FIG. 1 is a side, cross-sectional view of a microelectronic assembly 100 including an air gap fiducial, in accordance with various embodiments. A microelectronic assembly 100 may include a first microelectronic component 102-1 coupled to a second microelectronic component 102-2, where the first microelectronic component 102-1 aligned with the second microelectronic component 102-2 using an air gap fiducial 105. As used herein, an air gap fiducial 105 refers to a geometrically shaped space filled with air that is used to align and place microelectronic components 102 for coupling. In particular, the microelectronic assembly 100 may include a first microelectronic component 102-1 having a first bonding layer 130-1 with a first air gap fiducial 105-1 and a second microelectronic component 102-2 having a second bonding layer 130-2 with a second air gap fiducial 105-2, where the first air gap fiducial 105-1 and the second air gap fiducial 105-2 are nested. Although the first air gap fiducial 105-1 and the second air gap fiducial 105-2 are shown to extend an entire thickness (e.g., z-dimension) of the respective first and second bonding layers 130-1, 130-2, in some embodiments, the first air gap fiducial 105-1 and the second air gap fiducial 105-2 may not extend the entire thickness (e.g., as shown in FIG. 6C).

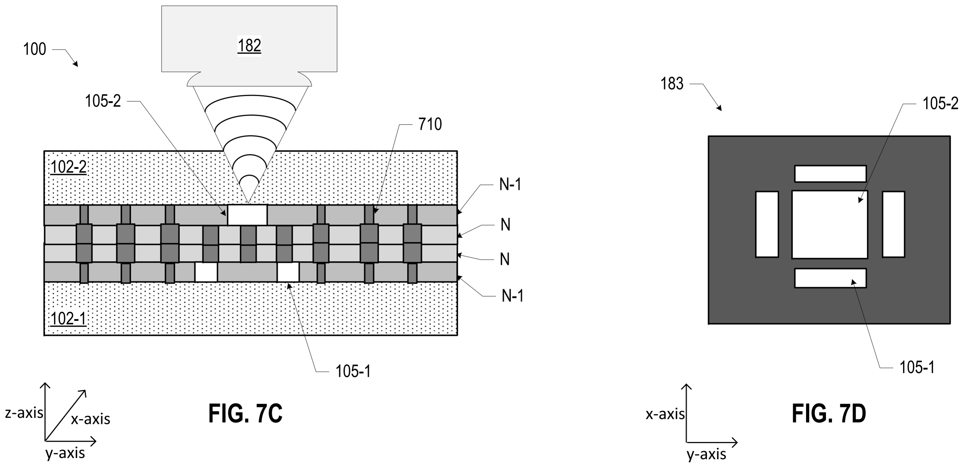

As shown in FIG. 2A, a first air gap fiducial 105-1 may include a plurality of air gaps (e.g., the four rectangular shaped air-filled spaces, as indicated by the darker outline) and a second air gap fiducial 105-2 may include a single air gap (e.g., the single rectangle shaped air-filled space, as indicated by the lighter outline), where the first air gap fiducial 105-1 and the second air gap fiducial 105-2 are aligned such that the second air gap fiducial 105-2 is nested in the first air gap fiducial 105-1 (e.g., the four air-filled rectangles of the first air gap fiducial 105-1 frame the single air filled rectangle of the second air gap fiducial 105-2) when viewed from a top surface (or a bottom surface) using an imaging system, as described below in more detail with reference to FIG. 7C. The first air gap fiducial 105-1 and the second air gap fiducial 105-2 are nested such that the air-filled spaces are aligned.

Returning to FIG. 1, the first microelectronic component 102-1 may be coupled to the second microelectronic component 102-2 by the first and second bonding layers 130-1, 130-2 at the bonding interface 130. The first bonding layer 130-1 may include first metal contacts 110-1 with a first dielectric material 108-1 between the first metal contacts 110-1 and the second bonding layer 130-2 may include second metal contacts 110-2 with a second dielectric material 108-2 between the second metal contacts 110-2. The first air gap fiducial 105-1 in the first bonding layer 130-1 of the first microelectronic component 102-1 and the second air gap fiducial 105-2 in the second bonding layer 130-2 of the second microelectronic component 102-2 and may be filled with air when the first microelectronic component 102-1 is bonded to the second microelectronic component 102-2. The first metal contacts 110-1 of the first bonding layer 130-1 may be coupled to the second metal contacts 110-2 of the second bonding layer 130-2 at the bonding interface 130 (e.g., forming metal-metal bonds). In some embodiments, the first dielectric material 108-1 of the first bonding layer 130-1 also may be coupled to the second dielectric material 108-2 of the second bonding layer 130-2 at the bonding interface 130 (e.g., forming dielectric-dielectric bonds). In some embodiments, the metal-metal bonds and/or dielectric-dielectric bonds may be formed by bringing the metal contacts 110 and dielectric material 108 into contact, and then subject to heat and sometimes compression. A dielectric material 108 may include one or more dielectric materials, such as one or more inorganic dielectric materials or one or more organic materials. A metal contact 110 may include a pillar, a pad, or other structure. A metal contact 110 may include any one or more conductive materials, such as copper, manganese, titanium, gold, silver, palladium, nickel, copper and aluminum (e.g., in the form of a copper aluminum alloy), tantalum (e.g., tantalum metal, or tantalum and nitrogen in the form of tantalum nitride), cobalt, cobalt and iron (e.g., in the form of a cobalt iron alloy), or any alloys of any of the foregoing (e.g., copper, manganese, and nickel in the form of manganin).

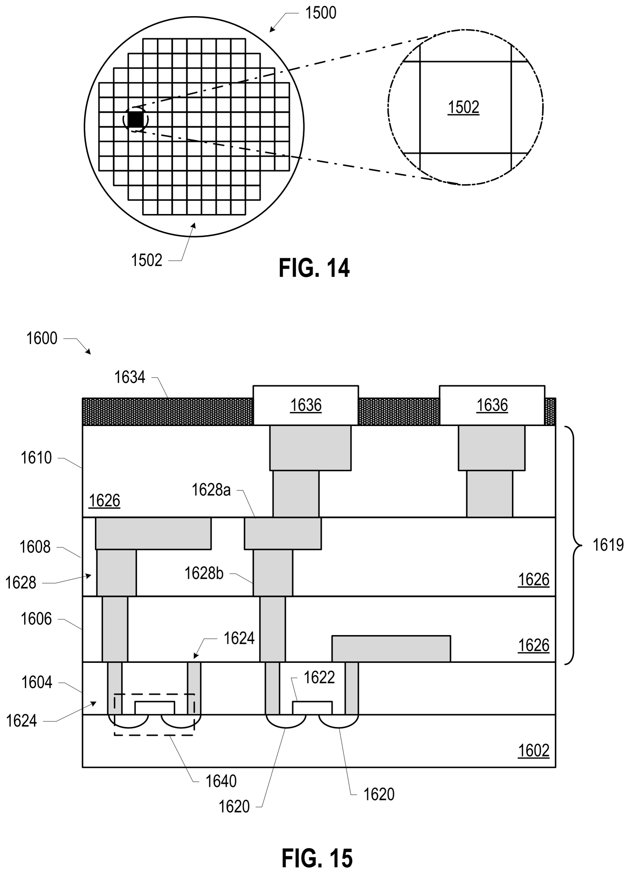

A microelectronic component 102 may include a silicon wafer or a die. For example, in some embodiments, a microelectronic component 102-1 may include a silicon wafer and a microelectronic component 102-2 may include a die (e.g., die-to-wafer bonding, where a plurality of dies are coupled to a wafer and subsequently singulated). In some embodiments, a microelectronic component 102-1 may include a die and a microelectronic component 102-2 may include another die (e.g., die-to-die bonding, where a die is coupled to another die). In some embodiments, a microelectronic component 102 may include an IC die (packaged or unpackaged) or a stack of an IC dies (e.g., a high-bandwidth memory dies stack). In some such embodiments, the insulating material of a microelectronic component 102 may include silicon dioxide, silicon nitride, oxynitride, polyimide materials, glass-reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some further embodiments, the insulating material of a microelectronic component 102 may include a semiconductor material, such as silicon, germanium, or a III-V material (e.g., gallium nitride), and one or more additional materials. For example, an insulating material of a microelectronic component 102 may include silicon oxide or silicon nitride. The conductive pathways in a microelectronic component 102 may include conductive lines and/or conductive vias, and may connect any of the conductive contacts in the microelectronic component 102 in any suitable manner (e.g., connecting multiple conductive contacts on a same surface or on different surfaces of the microelectronic component 102). Example structures that may be included in the microelectronic components 102 disclosed herein are discussed below with reference to FIG. 15. In particular, a microelectronic component 102 may include active and/or passive circuitry (e.g., transistors, diodes, resistors, inductors, and capacitors, among others). In some embodiments, a microelectronic component 102 may include one or more device layers including transistors.

The elements of a microelectronic assembly 100 may have any suitable dimensions. Only a subset of the accompanying drawings are labeled with reference numerals representing dimensions, but this is simply for clarity of illustration, and any of the microelectronic assemblies 100 disclosed herein may have components having the dimensions discussed herein. In some embodiments, the thickness 188 of the first and second bonding layers 130-1, 130-2 may be between 100 nanometers and 10 microns. In some embodiments, a thickness 190 of a microelectronic component 102 may be between 10 microns and 800 microns. In some embodiments, a pitch 128 of the metal contacts 110 in a bonding layer 130 may be equal to or less than 10 microns (e.g., between 100 nanometers and 10 microns). In some embodiments, a space 126 between metal contacts 110 may be between 50 nanometers and 5 microns.

Many of the elements of the microelectronic assembly 100 of FIG. 1 are included in other ones of the accompanying drawings; the discussion of these elements is not repeated when discussing these drawings, and any of these elements may take any of the forms disclosed herein.

FIG. 2A is a top view schematic of an example air gap fiducial of a microelectronic assembly, in accordance with various embodiments. To avoid over cluttering FIGS. 2A and 2B, the metal contacts (e.g., metal contacts 110, as shown in FIG. 1) have been omitted. In particular, a first air gap fiducial 105-1 and a second air gap fiducial 105-2 in respective bonding layers 130-1, 130-2. As described above, FIG. 2A shows a first air gap fiducial 105-1 including a plurality of air gaps (e.g., the four rectangular shaped air-filled spaces, as indicated by the darker outline) and a second air gap fiducial 105-2 may include a single air gap (e.g., the single square shaped air-filled space, as indicated by the lighter outline), where the first air gap fiducial 105-1 and the second air gap fiducial 105-2 are aligned with the second air gap fiducial 105-2 nested in the first air gap fiducial 105-1. In some embodiments, a first air gap fiducial 105-1 may have a surface area (e.g., an xy-dimension or a length 193 by a width 191) between 10 microns by 10 microns and 100 microns by 100 microns. In some embodiments, an individual portion of a second air gap fiducial 105-1 may have a surface area (e.g., an xy-dimension or a length 192 by a width 194) between 3 microns by 10 microns and 10 microns by 100 microns.

FIG. 2B is a side, cross-sectional view of the example air gap fiducial of FIG. 2A, in accordance with various embodiments. FIG. 2B shows the microelectronic assembly 100 of FIG. 2A along cross-section A-A'. In particular, the microelectronic assembly 100 of FIG. 2B may include a first microelectronic component 102-1 having a first bonding layer 130-1 with a first air gap fiducial 105-1 and a second microelectronic component 102-2 having a second bonding layer 130-2 with a second air gap fiducial 105-2, where the first air gap fiducial 105-1 and the second air gap fiducial 105-2 are nested when viewed by an imaging device from a top view.

FIG. 3A is a top view schematic of an example air gap fiducial of a microelectronic assembly, in accordance with various embodiments. To avoid over cluttering FIGS. 3A and 3B, the metal contacts (e.g., metal contacts 110, as shown in FIG. 1) have been omitted. The embodiment shown in the figure is similar to that of FIG. 2A, except that the first air gap fiducial 105-1 and the second air gap fiducial 105-2 include segmented air gaps that form a respective first air gap fiducial 105-1 (e.g., three rectangles forming each of the individual four rectangular shaped air-filled spaces) and a respective second air gap fiducial 105-2 (e.g., eight rectangles forming the single square shaped air-filled space). The segmented first air gap fiducial 105-1 and the segmented second air gap fiducial 105-2 are aligned such that the second air gap fiducial 105-2 is nested in the first air gap fiducial 105-1. The segmented first air gap fiducial 105-1 may have an overall surface area (e.g., an xy-dimension or a length 193 by a width 191) between 10 microns by 10 microns and 100 microns by 100 microns, and the segmented second air gap fiducial 105-1 may have an overall surface area (e.g., an xy-dimension or a length 192 by a width 194) between 3 microns by 10 microns and 10 microns by 100 microns.

FIG. 3B is a side, cross-sectional view of the example air gap fiducial of FIG. 3A, in accordance with various embodiments. FIG. 3B shows the microelectronic assembly 100 of FIG. 3A along cross-section A-A'. In particular, the microelectronic assembly 100 of FIG. 3B may include a first microelectronic component 102-1 having a first bonding layer 130-1 with a segmented first air gap fiducial 105-1 and a second microelectronic component 102-2 having a second bonding layer 130-2 with a segmented second air gap fiducial 105-2, where the segmented first air gap fiducial 105-1 and the segmented second air gap fiducial 105-2 are nested when viewed by an imaging device from a top view.

FIG. 4A is a top view schematic of an example air gap fiducial of a microelectronic assembly, in accordance with various embodiments. To avoid over cluttering FIGS. 4A and 4B, the metal contacts (e.g., metal contacts 110, as shown in FIG. 1) have been omitted. The embodiment shown in the figure is similar to that of FIG. 3A, except that the segmented first air gap fiducial 105-1 and the segmented second air gap fiducial 105-2 include segmented air gaps that comply with design rules of the first and second bonding layers 130-1, 130-2, respectively. In particular, the segmented first air gap fiducial 105-1 includes a three by seven array of air-filled squares forming each of the individual four rectangular shapes, and the segmented second air gap fiducial 105-2 includes eight by eight air-filled squares forming the single square shape. The segmented first air gap fiducial 105-1 and the segmented second air gap fiducial 105-2 are aligned such that the second air gap fiducial 105-2 is nested in the first air gap fiducial 105-1. In some embodiments, a bonding layer 130 may have a pitch (e.g., a pitch 128, as shown in FIG. 1) equal to 100 nanometers, and the segmented air-filled spaces may have a width (e.g., y-dimension) of approximately 50 nanometers and a space between the air-filled spaces equal to approximately 50 nanometers. The segmented first air gap fiducial 105-1 may have an overall surface area (e.g., an xy-dimension or a length 193 by a width 191, as shown in FIG. 3A) between 10 microns by 10 microns and 100 microns by 100 microns, and the segmented second air gap fiducial 105-1 may have an overall surface area (e.g., an xy-dimension or a length 192 by a width 194, as shown in FIG. 3A) between 3 microns by 10 microns and 10 microns by 100 microns.

FIG. 4B is a side, cross-sectional view of the example air gap fiducial of FIG. 4A, in accordance with various embodiments. FIG. 4B shows the microelectronic assembly 100 of FIG. 4A along cross-section A-A'. In particular, the microelectronic assembly 100 of FIG. 4B may include a first microelectronic component 102-1 having a first bonding layer 130-1 with a segmented first air gap fiducial 105-1 and a second microelectronic component 102-2 having a second bonding layer 130-2 with a segmented second air gap fiducial 105-2, where the segmented first air gap fiducial 105-1 and the segmented second air gap fiducial 105-2 are nested when viewed by an imaging device from a top view.

FIG. 5A is a top view schematic of an example air gap fiducial of a microelectronic assembly, in accordance with various embodiments. The embodiment shown in the figure is similar to that of FIG. 3A, except that the first air gap fiducial 105-1 includes segmented air gaps that form a cross and the second air gap fiducial 105-2 includes segmented air gaps that form four corner squares. The segmented first air gap fiducial 105-1 and the segmented second air gap fiducial 105-2 are aligned such that the first air gap fiducial 105-1 and the second air gap fiducial 105-2 are nested.

FIG. 5B is a top view schematic of another example air gap fiducial of a microelectronic assembly, in accordance with various embodiments. The embodiment shown in the figure is similar to that of FIG. 2A, except that the first air gap fiducial 105-1 and the second air gap fiducial 105-2 are not nested. In the embodiment shown in the figure, a first center point 101-1 of the first air gap fiducial 105-1 is aligned with a second center point 101-2 of the second air gap fiducial 105-2 (e.g., based on pre-determined y-distance and x-distance offsets). Although FIG. 5B illustrates first and second air gaps 105-1, 105-2 having particular geometrical shapes, sizes, and arrangements, non-nested air gap fiducials 105 may have any suitable geometrical shaped, sizes, and arrangements that enable alignment.

FIG. 5C is a top view schematic of yet another example air gap fiducial of a microelectronic assembly, in accordance with various embodiments. The embodiment shown in the figure is similar to that of FIG. 2A, except that the second air gap fiducial 105-2 includes a plurality of air gaps (e.g., the four rectangular shaped air-filled spaces, as indicated by the lighter outline) similar to the first air gap fiducial 105-1. The first air gap fiducial 105-1 and the second air gap fiducial 105-2 are aligned such that the first air gap fiducial 105-1 and the second air gap fiducial 105-2 are nested.

FIG. 5D is a top view schematic of an example air gap fiducial of a microelectronic assembly, in accordance with various embodiments. The embodiment shown in the figure is similar to that of FIG. 2A, except that the microelectronic assembly 100 includes a plurality of air gap fiducial 105 arranged in a grid at a bonding interface 130. As shown in FIG. 5D, an air gap fiducial 105 may include a first air gap fiducial 105-1 and a second air gap fiducial 105-2 and arranged in a repeating pattern (e.g., a grid as shown). Although FIG. 5D illustrates an air gap fiducial 105 having a particular nested geometrical shape and in a particular arrangement, a microelectronic assembly 100 may have an air gap fiducial 105 with any particular geometrical shape (e.g., any of the air gap fiducial 105 shown in FIGS. 3, 4, 5A, 5B, or 5C, among others) and any particular arrangement for aligning and placing microelectronic components 102. The embodiment shown in FIG. 5D allows for dense overlay sampling of air gap fiducials 105 for more precise alignment and positioning.

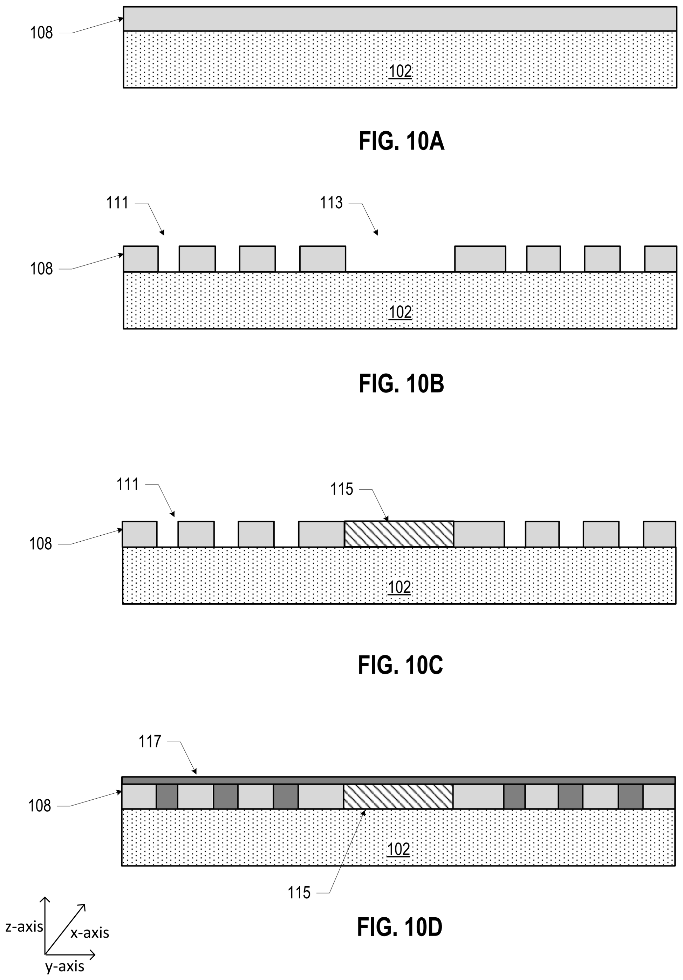

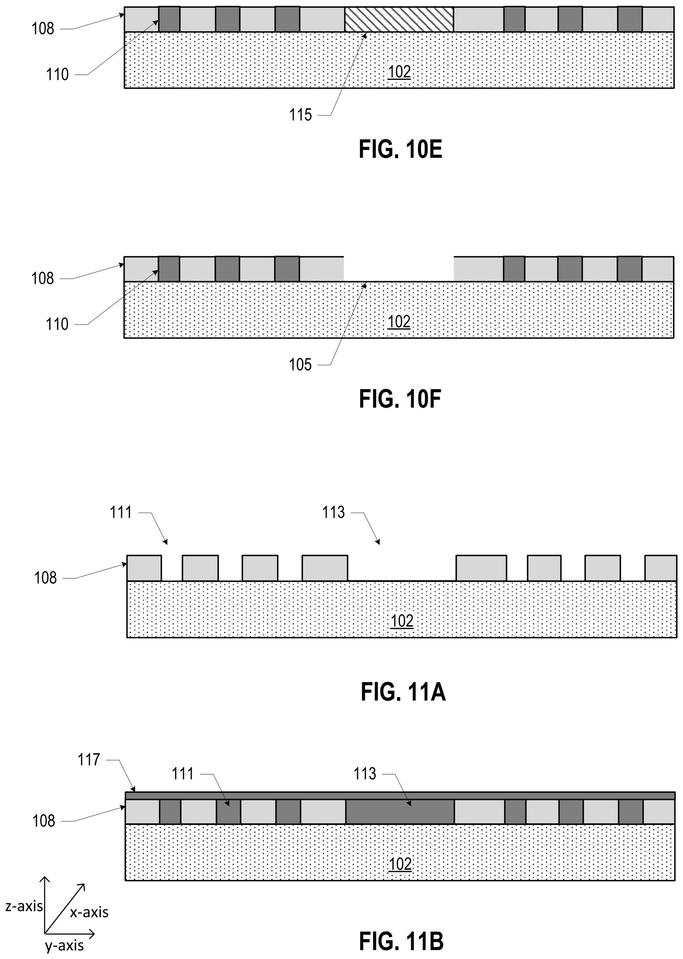

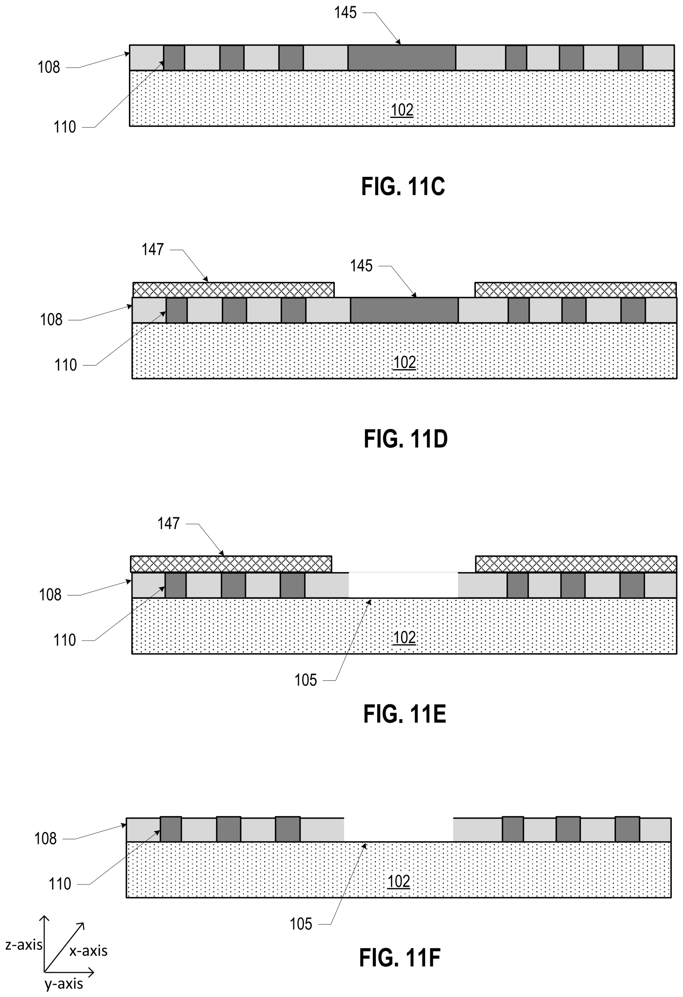

FIG. 6A is a side, cross-sectional view of a microelectronic assembly 100 including an air gap fiducial, in accordance with various embodiments. The embodiment shown in the figure is similar to that of FIG. 1, except that the first air gap fiducial 105-1 and the second air gap fiducial 105-2 are in a layer adjacent to the respective bonding layers 130-1, 130-2. In particular, a microelectronic assembly 100 may include a first microelectronic component 102-1 having a first bonding layer 130-1, also referred to herein as the N layer, and an N-1 layer adjacent to the N layer with a first air gap fiducial 105-1, and a second microelectronic component 102-2 having a second bonding layer 130-2, also referred to herein as the N layer, and an N-1 layer adjacent to the N layer with a second air gap fiducial 105-1, where the first microelectronic component 102-1 and the second microelectronic component 102-2 are coupled, and where the first air gap fiducial 105-1 and the second air gap fiducial 105-2 are aligned. The N and N-1 layers may be part of a semiconductor front end process and the air gap fiducial 105 may be patterned simultaneously with the front end process, as described below with reference to FIGS. 10 and 11.

FIG. 6B is a side, cross-sectional view of a microelectronic assembly 100 including an air gap fiducial, in accordance with various embodiments. The embodiment shown in the figure is similar to that of FIG. 6A, except that the first air gap fiducial 105-1 and the second air gap fiducial 105-2 include segmented air gaps.

FIG. 6C is a side, cross-sectional view of a microelectronic assembly 100 including an air gap fiducial, in accordance with various embodiments. The embodiment shown in the figure is similar to that of FIG. 6A, except that the first air gap fiducial 105-1 and the second air gap fiducial 105-2 include air gaps that do not extend an entire thickness (e.g., z-dimension) of the respective N-1 layers.

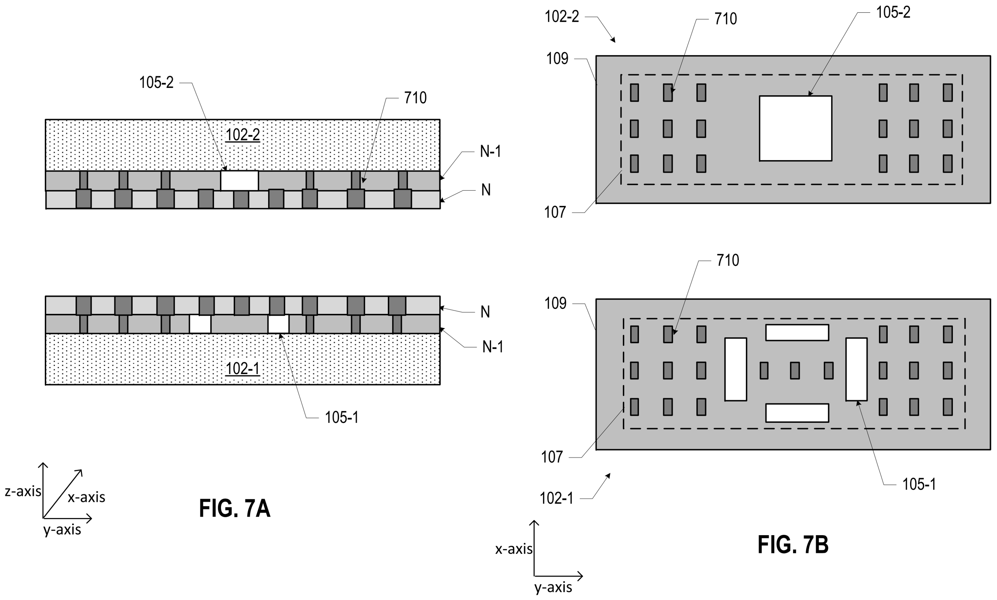

FIG. 7A is a side, cross-sectional view of example microelectronic components including air gap fiducials, in accordance with various embodiments. FIG. 7A is similar to FIG. 6A except that the first microelectronic component 102-1 and the second microelectronic component 102-2 are not bonded.

FIG. 7B are schematic bottom and top views of respective layers of the microelectronic components 102 of FIG. 7A including air gap fiducials 105, in accordance with various embodiments. The top figure is a bottom view of the N-1 layer of the second microelectronic component 102-2 including a second air gap fiducial 105-2, metal contacts 710, an active area 107, and a perimeter area 109. The bottom figure is a top view of the N-1 layer of the first microelectronic component 102-1 including a first air gap fiducial 105-1, metal contacts 710, an active area 107, and a perimeter area 109. An active area 107 refers to an area of a microelectronic component 102 that has active components and interconnects. A perimeter area 109 of a microelectronic component 102 refers to an area of a microelectronic component 102 that does not include active components and interconnects. As shown in FIG. 7B, the first air gap fiducial 105-1 and the second air gap fiducial 105-2 are in an active area 107 of the respective microelectronic components 102-1, 102-2. Traditionally, fiducials have been included in the perimeter area 109 and not in the active area 107 of a microelectronic component 102.

FIG. 7C is a side, cross-sectional view of an example microelectronic assembly of FIG. 7A including an air gap fiducial undergoing imaging, in accordance with various embodiments. An imaging device 182 may include any suitable device that can detect the air gap fiducial 105. In some embodiments, an imaging device 182 may include photoacoustic imaging, which involves using short laser pulses (e.g., a pump beam) which may penetrate the microelectronic assembly 100 and cause rapid heating of features of interest, thereby generating acoustic waves that are detected via acoustic transducers at the surface of the microelectronic assembly 100, or may heat the surface of the microelectronic assembly 100 thereby launching a strain (e.g., acoustic) pulse that propagates through the microelectronic assembly 100 and reflects back upon encountering a significantly large impedance mismatch. This reflected acoustic pulse can be sensed by a time delayed optical pulse (e.g., a probe beam) at the surface the microelectronic assembly 100. Varying the probe pulse delay allows for probing at different thicknesses (e.g., z-dimension) of the microelectronic assembly 100. The wavelengths of the pump may be tailored to obtain maximum impedance contrast at the air gap fiducial 105, thus allowing a raster/scanning pump/probe/acoustic transducer assembly to map out an air gap fiducial 105 despite the presence of opaque layers and metals in the microelectronic assembly 100.

In some embodiments, an imaging device 182 may include Refractive Index Tomography, which utilizes the phase changes in coherent light (e.g. laser illumination) from multiple angles as it passes through partially transparent materials to reconstruct a 3-dimensional map of refractive index in the sample. This is a very precise and fast technique that can image embedded features in a partially transmissive sample with nanometer level thickness (e.g., z-dimension) resolution and approximately 150 nanometer lateral (e.g., xy-dimension) resolution. The laser wavelength may be tailored to penetrate through layers of the microelectronic assembly 100 and obtain maximum contrast of the air gap fiducial 105 (e.g., at the air gap fiducial 105 and the dielectric material interface).

In some embodiments, an imaging device 182 may include C-Mode Scanning Acoustic Microscopy (CSAM), which utilizes a high frequency ultrasonic transducer paired with a coupling medium, such as water, to send acoustic waves through a microelectronic assembly 100. These acoustic waves are reflected back at interfaces with high impedance mismatch (e.g. at the air gap fiducial 105 and the dielectric material interface) and are detected by the transducer to create a 2-Dimensional/3-Dimensional map of the air-filled spaces of the air gap fiducial 105, despite the presence of underlayer metallization in the microelectronic assembly 100.

FIG. 7D is a schematic image of the air gap fiducial of FIG. 7C, in accordance with various embodiments. FIG. 7D illustrates an example image 183 produced by imaging device 182 of FIG. 7C that detects the air-filled geometrically shaped spaces of the first air gap fiducial 105-1 and the second air gap fiducial 105-2. The image 183 may be used to determine alignment precision between the first and second microelectronic components 102-1, 102-2 and provide adjustments to the system for improved placement.

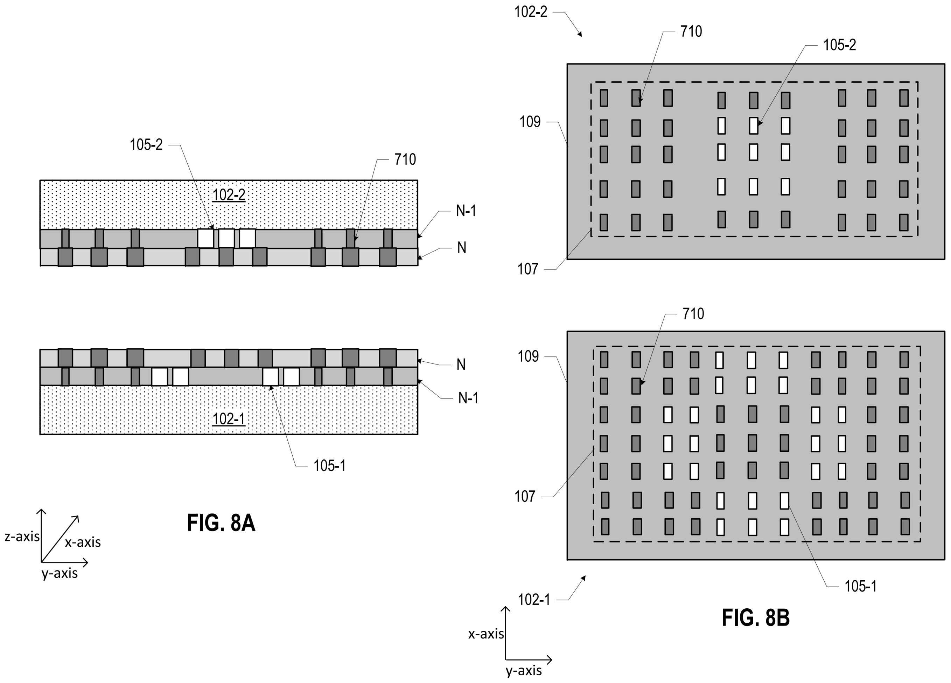

FIG. 8A is a side, cross-sectional view of example microelectronic components including air gap fiducials, in accordance with various embodiments. FIG. 8A is similar to FIG. 6B except that the first microelectronic component 102-1 and the second microelectronic component 102-2 are not bonded.

FIG. 8B are schematic bottom and top views of respective layers of the microelectronic components 102 of FIG. 8A including air gap fiducials 105, in accordance with various embodiments. The top figure is a bottom view of the N-1 layer of the second microelectronic component 102-2 including a segmented second air gap fiducial 105-2, metal contacts 710, an active area 107, and a perimeter area 109. The bottom figure is a top view of the N-1 layer of the first microelectronic component 102-1 including a segmented first air gap fiducial 105-1, metal contacts 710, an active area 107, and a perimeter area 109. As shown in FIG. 8B, the segmented first air gap fiducial 105-1 and the segmented second air gap fiducial 105-2 are in an active area 107 of the respective microelectronic components 102-1, 102-2.

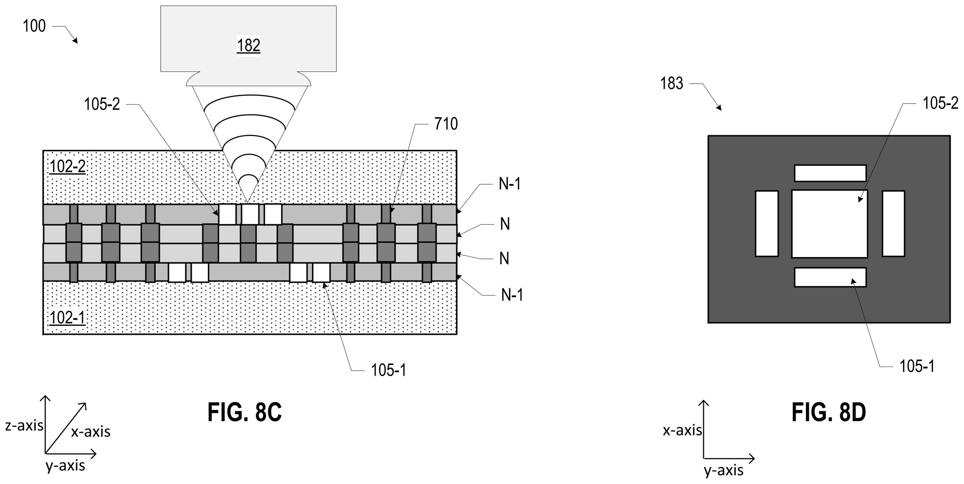

FIG. 8C is a side, cross-sectional view of an example microelectronic assembly of FIG. 8A including an air gap fiducial undergoing imaging, in accordance with various embodiments. An imaging device 182 may include any suitable device that can detect the air gap fiducial 105, including those described above with reference to FIG. 7C.

FIG. 8D is a schematic image of the air gap fiducial of FIG. 8C, in accordance with various embodiments. FIG. 8D illustrates an example image 183 produced by imaging device 182 of FIG. 8C that detects the air-filled geometrically shaped spaces of the segmented first air gap fiducial 105-1 and the segmented second air gap fiducial 105-2, where the imaging device 182 via the image 183 identifies the segmented first air gap fiducial 105-1 as four air-filled spaces and the segmented second air gap fiducial 105-2 as a single air-filled space.

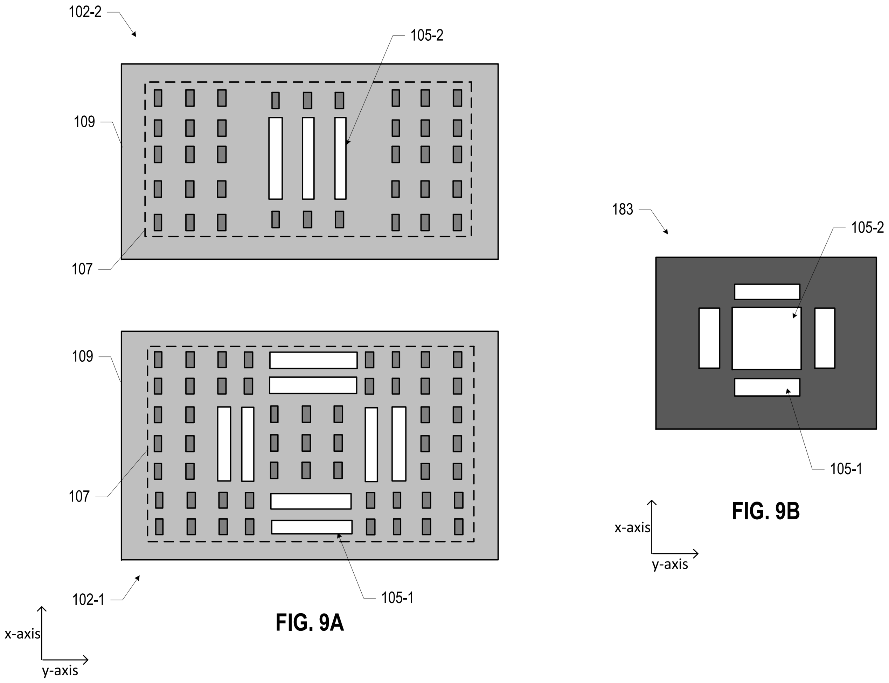

FIG. 9A are schematic bottom and top views of respective layers of a microelectronic components 102 similar to FIG. 8A including air gap fiducials 105, in accordance with various embodiments. The top figure is a bottom view of the N-1 layer of the second microelectronic component 102-2 including a segmented second air gap fiducial 105-2, metal contacts 710, an active area 107, and a perimeter area 109. The bottom figure is a top view of the N-1 layer of the first microelectronic component 102-1 including a segmented first air gap fiducial 105-1, metal contacts 710, an active area 107, and a perimeter area 109. As shown in FIG. 8B, the segmented first air gap fiducial 105-1 and the segmented second air gap fiducial 105-2 are in an active area 107 of the respective microelectronic components 102-1, 102-2.

FIG. 9B is a schematic image of an air gap fiducial of FIG. 9A in a microelectronic assembly 100, in accordance with various embodiments. FIG. 9B illustrates an example image 183 produced by imaging device (e.g., an imaging device 182 of FIG. 8C) that detects the air-filled geometrically shaped spaces of the segmented first air gap fiducial 105-1 and the segmented second air gap fiducial 105-2 of FIG. 9A, where the image 183 identifies the segmented first air gap fiducial 105-1 as four air-filled spaces and the segmented second air gap fiducial 105-2 as a single air-filled space.

Any suitable techniques may be used to manufacture the microelectronic assemblies disclosed herein. FIGS. 10A-10F are side, cross-sectional views of various stages in an example process for manufacturing an example microelectronic component 102, in accordance with various embodiments. Although the operations discussed below with reference to FIGS. 10A-10F are illustrated in a particular order, these operations may be performed in any suitable order.

FIG. 10A illustrates a microelectronic component 102 including a dielectric material 108 deposited on a top surface. A dielectric material 108 may be deposited using any suitable technique, such as lamination.

FIG. 10B illustrates an assembly subsequent to patterning openings 111, 113 into the dielectric material 108. The size and shape of the openings 111, 113 may depend on the features being formed. For example, openings 111 may be for metal contacts (e.g., metal contacts 110 of FIG. 1) and opening 113 may be for an air gap fiducial (e.g., air gap fiducial 105 of FIG. 1). The openings 111, 113 may be formed using any suitable technique, such as lithography.

FIG. 10C illustrates an assembly subsequent to depositing a plug material 115 into opening 113. The plug material 115 may include any suitable material, such as silicon nitride, silicon oxide, silicon carboxy nitride (SiOCN), a metallic compound (e.g., TiN), amorphous carbon, spin on carbon, or a sacrificial polymer. The plug material 115 may be deposited using any suitable technique. For example, the plug material 115 may be a selectively deposited or may be blanket deposited, polished back and preserved.

FIG. 10D illustrates an assembly subsequent to depositing a conductive material 117 on a top surface of the assembly and in the openings 111. The conductive material 117 may include any suitable conductive material, including a metal such as copper, and may be deposited using any suitable technique.

FIG. 10E illustrates an assembly subsequent to polishing the top surface of the assembly of FIG. 10D to remove the top layer of conductive material 117 and form metal contacts 110. The conductive material 117 may be removed using any suitable technique, such as etching.

FIG. 10F illustrates an assembly subsequent to removing the plug material 115 and forming air gap fiducial 105. The plug material 115 may be removed using any suitable technique. Further operations may be performed on the assembly of FIG. 10F, including bonding the microelectronic component 102 to another microelectronic component 102 with an air gap fiducial 105 to form a microelectronic assembly 100 similar to FIG. 1.

FIGS. 11A-11F are side, cross-sectional views of various stages in an example process for manufacturing an example microelectronic component 102, in accordance with various embodiments. Although the operations discussed below with reference to FIGS. 11A-11F are illustrated in a particular order, these operations may be performed in any suitable order.

FIG. 11A illustrates a microelectronic component 102 including a dielectric material 108 deposited on a top surface and patterning openings 111, 113 into the dielectric material 108. The assembly of FIG. 11A may be formed using any suitable technique, such as described above with reference to FIGS. 10A and 10B.

FIG. 11B illustrates an assembly subsequent to depositing a conductive material 117 on a top surface of the assembly and in the openings 111, 113.

FIG. 11C illustrates an assembly subsequent to polishing the top surface of the assembly of FIG. 10D to remove the top layer of conductive material 117 forming metal contacts 110 and conductive feature 145.

FIG. 11D illustrates an assembly subsequent to depositing and patterning a mask material 147 on a top surface of assembly of FIG. 11C and exposing the conductive feature 145.

FIG. 11E illustrates an assembly subsequent to removing the conductive material from the conductive feature 145 to form air gap fiducial 105. The conductive material may be removed using any suitable technique, such as selective etching.

FIG. 11F illustrates an assembly subsequent to removing the mask material 147. Further operations may be performed on the assembly of FIG. 11F, including bonding the microelectronic component 102 to another microelectronic component 102 with an air gap fiducial 105 to form a microelectronic assembly 100 similar to FIG. 1. Although the operations in FIGS. 10 and 11 illustrate forming an air gap fiducial 105 in an N layer (e.g., bonding layer 130 in FIG. 1), these operations may be applied to form an air gap fiducial 105 in an N-a layer of a microelectronic component 102. Although the operations in FIGS. 10 and 11 illustrate a single microelectronic component 102, multiple microelectronic components 102 may manufactured together and subsequently singulated.

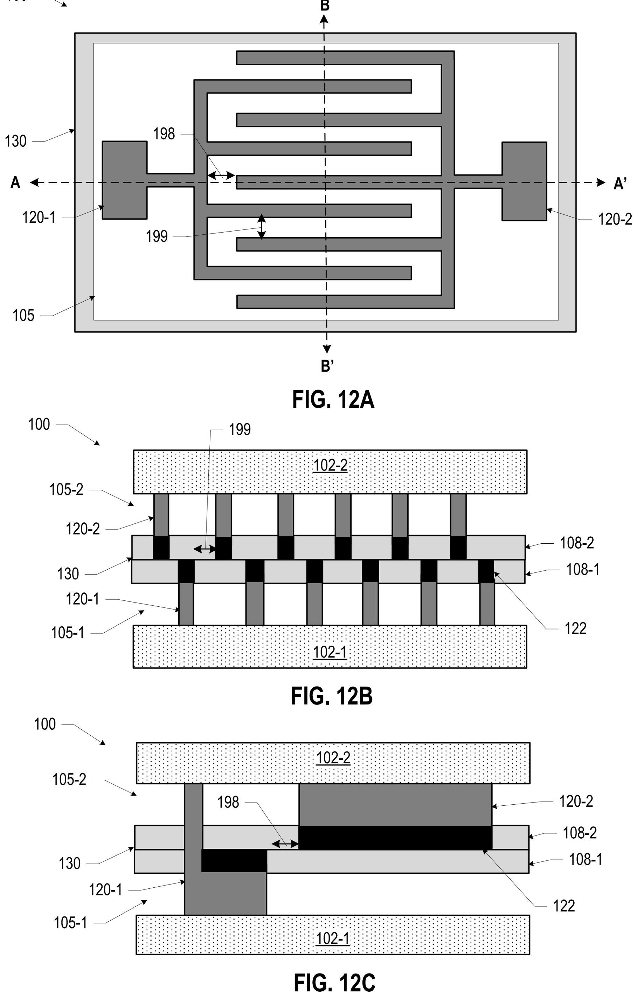

FIG. 12A is a schematic top view of an example microelectronic assembly including a capacitive comb structure with an air gap fiducial, in accordance with various embodiments. FIG. 12A illustrates a schematic top view of a bonding interface 130 in a microelectronic assembly 100 between a first microelectronic component 102-1 and a second electronic component 102-2 (e.g., as shown in FIG. 1) including an air gap fiducial 105 and a comb capacitor 120. In particular, a comb capacitor 120 may include a first comb portion 120-1 and a second comb portion 120-2 arranged with interdigitated fingers. Air-filled spaces 198, 199 of the air gap fiducial 105 (e.g., a first air gap fiducial 105-1 and a second air gap fiducial 105-2, as shown in FIGS. 12B and 12C) may be used to determine the alignment or misalignment of the interdigitated fingers (e.g., overlay of the first comb portion 120-1 relative to the second comb portion 120-2).

A comb capacitor 120 may further function as a fiducial, as well as a capacitor structure in a microelectronic assembly 100. Capacitance shift may be used to measure the alignment of comb capacitor portions 120-1, 120-2. Capacitance in comb capacitors 120 changes based on the alignment and spacing of the interdigitated fingers. When the alignment of the comb fingers changes, the capacitance between them changes. By measuring this capacitance shift, the degree of misalignment or displacement may be determined. The more overlap there is between the fingers, the greater the capacitance. As the fingers move closer together or align more precisely, the surface area between the conductive plates (i.e., fingers) increases, leading to a higher capacitance. The capacitance decreases as the gap between the fingers increases. Larger spacing reduces the electric field interaction between the fingers, thereby reducing the capacitance. If the fingers are misaligned, the effective overlapping area changes, resulting in a shift in capacitance. Small shifts in alignment may create noticeable changes in the capacitance value. The relationship between capacitance and finger alignment may be calculated using the formula for parallel plate capacitance: *C = ε*(*A*/*d*)*,* where *C* is the capacitance, *ε* is the permittivity of the dielectric material between the plates, *A* is the overlapping area of the plates, and *d* is the distance between the plates. In the case of comb capacitors, *A* is influenced by the degree of overlap and alignment of the comb fingers and *d* is the spacing between adjacent fingers. Achieving the desired capacitance value in comb capacitors requires precise alignment and consistent spacing of the fingers, which effectively functions as a fiducial marker.

Measuring capacitance accurately in the context of comb capacitors may involve using a high-precision capacitance meter or an LCR meter capable of accurately measuring small capacitances. An LCR meter is a type of electronic test equipment used to measure the inductance (L), capacitance (C), and resistance (R) of electronic components. "5-term," "14-term," and "33-term" capacitance measurements refer to the number of terms or parameters considered in the mathematical model used to measure and analyze capacitance. These terms can include various factors such as parasitic inductance, resistance, and other elements that affect the accuracy and precision of the capacitance measurement. A 5-term measurement method typically includes measuring the capacitance, series resistance, and three parasitic elements. A 14-term measurement method includes a more comprehensive set of parameters, considering 14 different factors that can influence the measurement. A 33-term measurement method is the most detailed and accurate method that considers 33 different parameters including a wide range of parasitic elements, environmental factors, and other influences on the capacitance measurement.

Additionally, a microelectronic component 102 may have a unique or series of unique physical unclonable functions (PUFs) based on a comb capacitor 120 that may be utilized for enhancing microelectronic component 102 security. Further, the interdigitated fingers of a comb capacitor 120 may allow for an electrical assessment and passive metrology assessment of bond health. A Physical Unclonable Function (PUF) is a unique physical entity that generates a unique response to a given input, making it virtually impossible to clone or replicate. PUFs are often used in hardware security to provide a unique identifier for electronic devices, such as microprocessors or integrated circuits. Each PUF is unique due to the inherent physical variations that occur during the manufacturing process. These variations are unpredictable and cannot be duplicated, even if the manufacturing process is repeated. For example, when a specific input is applied to the PUF, it generates a unique output based on its physical properties. This response can be used for authentication and security purposes.

FIGS. 12B and 12C are side, cross-sectional views of the example microelectronic assembly of FIG. 12A including a capacitive comb structure with an air gap fiducial, in accordance with various embodiments. FIG. 12B illustrates the microelectronic assembly 100 of FIG. 12A along cross-section A-A' including a first microelectronic component 102-1 having a first portion 120-1 of a comb capacitor 120 with a cap material 122 (e.g., a nitride cap) surrounded by a dielectric material 108-1 and a first air gap fiducial 105-1 below the dielectric material 108-1, and a second microelectronic component 102-2 having a second portion 120-2 of a comb capacitor 120 with a cap material 122 surrounded by a dielectric material 108-2 and a second air gap fiducial 105-2 above the dielectric material 108-1. FIG. 12C illustrates the microelectronic assembly 100 of FIG. 12A along cross-section B-B' including a first microelectronic component 102-1 having a first portion 120-1 of a comb capacitor 120 with a cap material 122 surrounded by a dielectric material 108-1 and a first air gap fiducial 105-1 below the dielectric material 108-1, and a second microelectronic component 102-2 having a second portion 120-2 of a comb capacitor 120 with a cap material 122 surrounded by a dielectric material 108-2 and a second air gap fiducial 105-2 above the dielectric material 108-1.

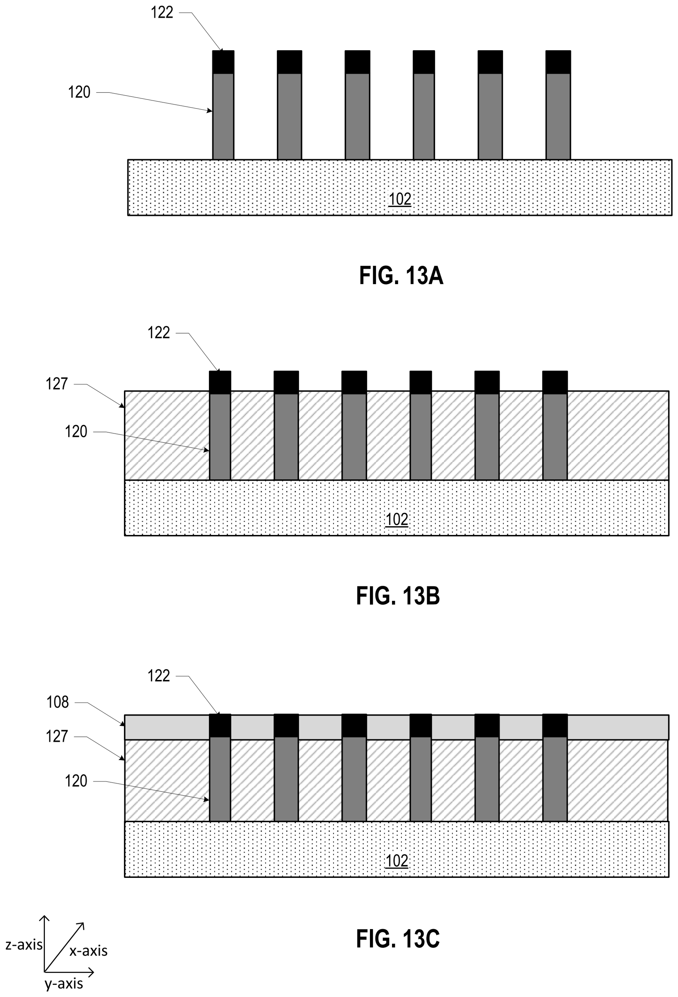

FIGS. 13A-13H are side, cross-sectional views of various stages in an example process for manufacturing a microelectronic component including a capacitive comb structure with an air gap fiducial, in accordance with various embodiments.

FIG. 13A illustrates a microelectronic component 102 including a first conductive material, such as copper, deposited and patterned on a top surface to form a portion of a comb capacitor 120. The top surfaces of the comb capacitor 120 may include a cap material 122, such as nitride.

FIG. 13B illustrates an assembly subsequent to providing a sacrificial material 127 around the portion of the comb capacitor 120. In some embodiments, the sacrificial material 127 may be deposited over the cap material 122 and subsequently removed.

FIG. 13C illustrates an assembly subsequent to depositing a dielectric material 108 on a top surface of the assembly and around the cap material 122. The dielectric material 108 may be deposited using a gap fill dielectric deposition process and a tops surface of the dielectric material 108 may be polished, for example, using chemical and mechanical polishing (CMP).

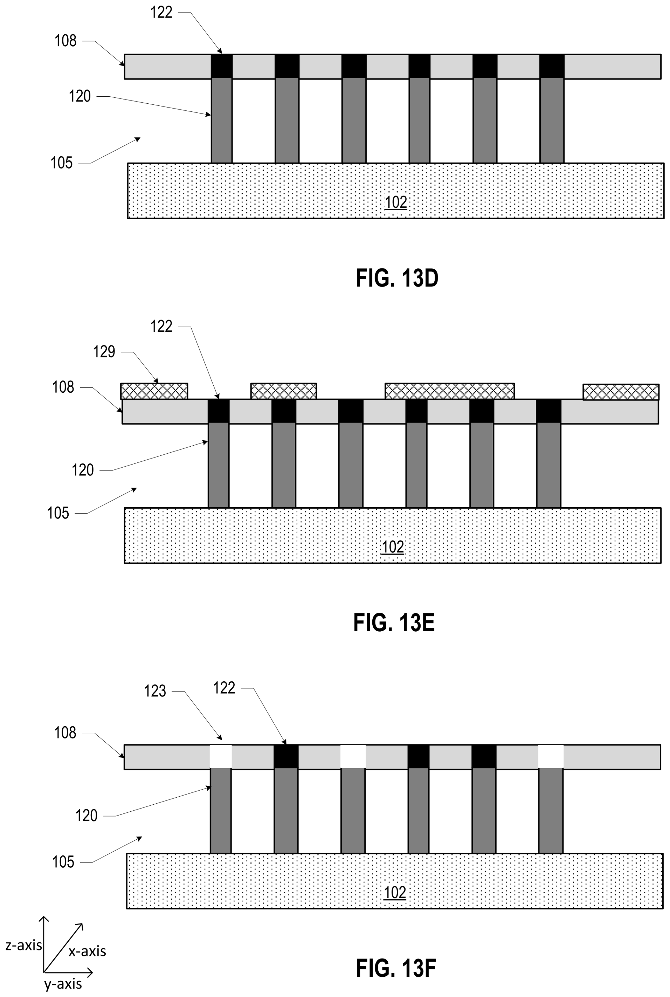

FIG. 13D illustrates an assembly subsequent to removing the sacrificial material 127 and forming an air gap fiducial 105.

FIG. 13E illustrates an assembly subsequent to depositing a mask material 129 to expose some of the cap material 122.

FIG. 13F illustrates an assembly subsequent to selectively removing the cap material 122 from the exposed portions to form openings 123 and removing the mask material 129.

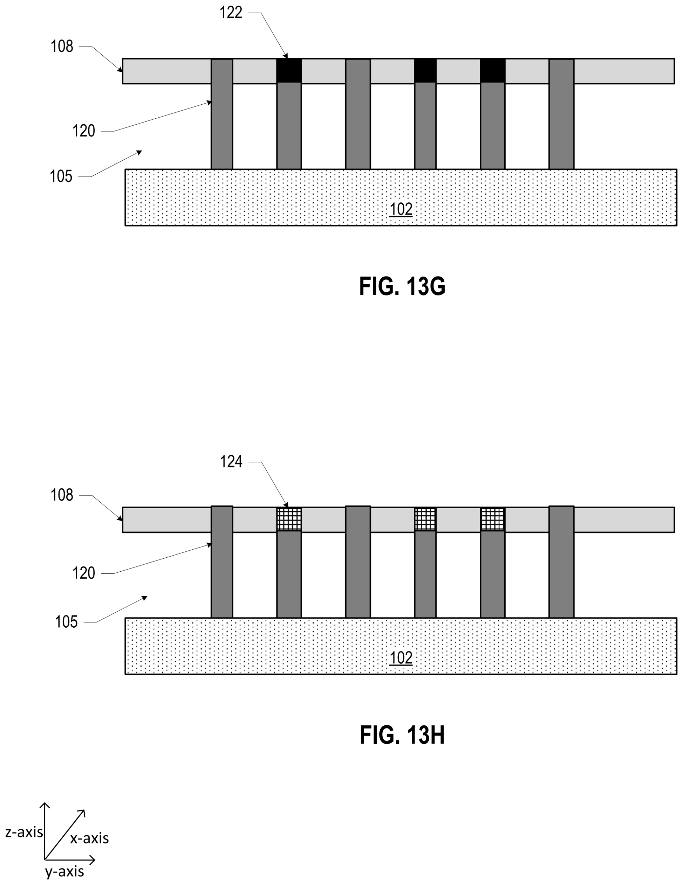

FIG. 13G illustrates an assembly subsequent to depositing a conductive material, such as copper, in the openings 123 to form comb capacitor 120 portions that may couple to another microelectronic component (e.g., such as shown in FIG. 12C).

FIG. 13H illustrates an assembly subsequent to removing the cap material 122 and depositing another material 124, such as a lower k dielectric material. The operation in FIG. 13H is optional.

The microelectronic components 102 and microelectronic assemblies 100 disclosed herein may be included in any suitable electronic component. FIGS. 14-17 illustrate various examples of apparatuses that may include, or be included in, as suitable, any of the microelectronic components 102 and microelectronic assemblies 100 disclosed herein.

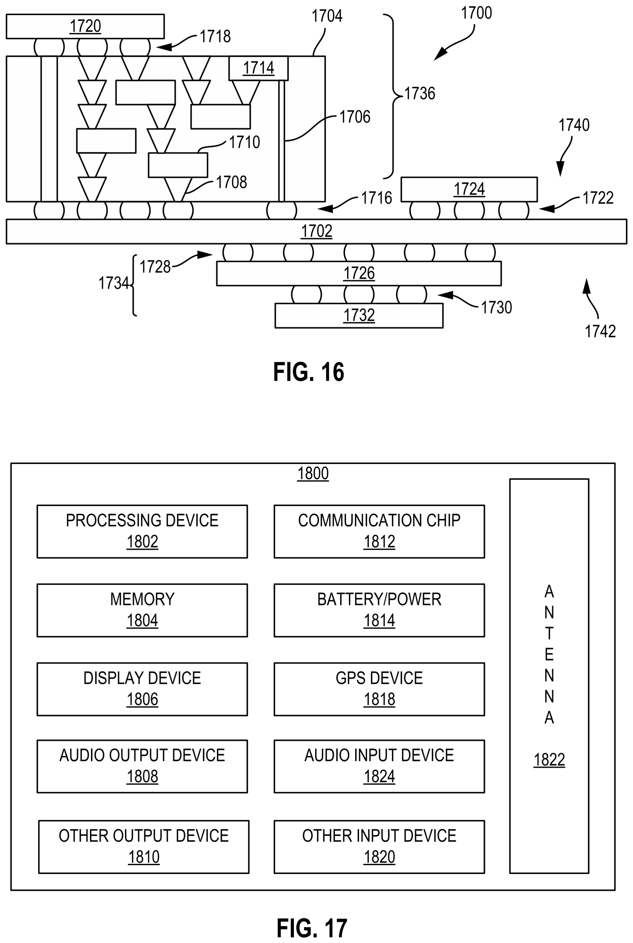

FIG. 14 is a top view of a wafer 1500 and dies 1502 that may be included in any of the microelectronic components 102 disclosed herein. For example, a die 1502 may serve as a microelectronic component 102, or may be included in a microelectronic component 102. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 15, discussed below) and/or supporting circuitry to route electrical signals to the transistors, as well as any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 17) or other logic that is configured to store information in the memory devices or execute instructions stored in the memory array.

FIG. 15 is a side, cross-sectional view of an IC device 1600 that may be included in any of the microelectronic components 102 disclosed herein. For example, an IC device 1600 (e.g., as part of a die 1502, as discussed above with reference to FIG. 14) may serve as a microelectronic component 102, or may be included in a microelectronic component 102. One or more of the IC devices 1600 may be included in one or more dies 1502 (FIG. 14). The IC device 1600 may be formed on a substrate 1602 (e.g., the wafer 1500 of FIG. 14) and may be included in a die (e.g., the die 1502 of FIG. 14). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 14) or a wafer (e.g., the wafer 1500 of FIG. 14).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 15 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 15 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 15). Although a particular number of interconnect layers 1606-1610 is depicted in FIG. 15, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 15. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 15. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 15, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

FIG. 16 is a side, cross-sectional view of an IC device assembly 1700 that may include any of the microelectronic components 102 and/or microelectronic assemblies 100 disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may include any of the embodiments of the microelectronic assemblies 100 disclosed herein (e.g., may include multiple microelectronic components 102 coupled together by direct bonding).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 16 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 16), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 16, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 14), an IC device (e.g., the IC device 1600 of FIG. 15), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 16, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to TSVs 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 16 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 17 is a block diagram of an example electrical device 1800 that may include any of the microelectronic components 102 and/or microelectronic assemblies 100 disclosed herein. For example, any suitable ones of the components of the electrical device 1800 may include one or more of the IC device assemblies 1700, IC devices 1600, or dies 1502 disclosed herein. A number of components are illustrated in FIG. 17 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 17, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides a microelectronic component, including a plurality of layers having a first surface and an opposing second surface, where at least one of the plurality of layers includes an active area; and a fiducial in the active area of the at least one of the plurality of layers, where the fiducial includes a geometrically shaped space filled with air.

Example 2 provides the microelectronic component of example 1, where the at least one of the plurality of layers is at the first surface.

Example 3 provides the microelectronic component of example 1 or 2, where the at least one of the plurality of layers is adjacent to the first surface.

Example 4 provides the microelectronic component of any one of examples 1-3, where a surface area of the geometrically shaped space filled with air is between 10 microns by 10 microns and 100 microns by 100 microns.

Example 5 provides the microelectronic component of any one of examples 1-4, where the fiducial is one of a plurality of fiducials.

Example 6 provides the microelectronic component of example 5, where the plurality of fiducials are arranged in a grid.

Example 7 provides the microelectronic component of any one of examples 1-6, where the geometrically shaped space filled with air includes a plurality of segments.

Example 8 provides a microelectronic assembly, including a first microelectronic component including a first bonding layer with a first air gap fiducial; and a second microelectronic component including a second bonding layer with a second air gap fiducial, where the first microelectronic component is coupled to the second microelectronic component by the first and second bonding layers, and where the first air gap fiducial and the second air gap fiducial are aligned.

Example 9 provides the microelectronic assembly of example 8, where the first air gap fiducial is within an active area of the first microelectronic component and the second air gap fiducial is within an active area of the second microelectronic component.

Example 10 provides the microelectronic assembly of example 8 or 9, where the first air gap fiducial includes a plurality of first air gap segments and the second air gap fiducial includes a plurality of second air gap segments.

Example 11 provides the microelectronic assembly of any one of examples 8-10, where the first bonding layer includes a first dielectric material between adjacent ones of first metal contacts, where the second bonding layer includes a second dielectric material between adjacent ones of second metal contacts, where individual first metal contacts in the first bonding layer are coupled to respective individual second metal contacts in the second bonding layer, and where the first metal contacts and the second metal contacts have a pitch equal to or less than 10 microns.

Example 12 provides the microelectronic assembly of any one of examples 8-11, where the first air gap fiducial includes a rectangle and the second air gap fiducial includes four rectangles framing the first air gap fiducial.

Example 13 provides the microelectronic assembly of example 12, where the first air gap fiducial has a surface area between 10 microns by 10 microns and 100 microns by 100 microns and an individual rectangle of the four rectangles of the second air gap fiducial has a surface area between 3 microns by 10 microns and 10 microns by 100 microns.

Example 14 provides the microelectronic assembly of any one of examples 8-13, where the first air gap fiducial is one of a plurality of first air gap fiducials and the second air gap fiducial is one of a plurality of second air gap fiducials.

Example 15 provides the microelectronic assembly of example 14, where the plurality of first air gap fiducials and the plurality of second air gap fiducials are arranged in a grid.

Example 16 provides the microelectronic assembly of any one of examples 8-15, where the first air gap fiducial and the second air gap fiducial are aligned with the first air gap fiducial nested in the second air gap fiducial.

Example 17 provides a microelectronic assembly, including a first microelectronic component including a first surface with a first air gap fiducial in an N-1 layer adjacent to an N layer at the first surface; and a second microelectronic component including a second surface with a second air gap fiducial in an N-1 layer adjacent to an N layer at the second surface, where the first microelectronic component is coupled to the second microelectronic component, and where the first air gap fiducial and the second air gap fiducial are aligned.

Example 18 provides the microelectronic assembly of example 17, where the first air gap fiducial is within an active area of the first microelectronic component and the second air gap fiducial is within an active area of the second microelectronic component.

Example 19 provides the microelectronic assembly of example 17 or 18, where the first air gap fiducial is one of a plurality of first air gap fiducials and the second air gap fiducial is one of a plurality of second air gap fiducials.

Example 20 provides the microelectronic assembly of example 19, where the plurality of first air gap fiducials and the plurality of second air gap fiducials are arranged in a grid.

Example 21 provides the microelectronic assembly of any one of examples 17-20, further including a first portion of a comb capacitor including first fingers in the N layer and in the first air gap fiducial in the N-1 layer of the first microelectronic component; and a second portion of a comb capacitor including second fingers in the N layer and in the second air gap fiducial in the N-1 layer of the second microelectronic component, where the first fingers and the second fingers are interdigitated.

Example 22 provides the microelectronic assembly of any one of examples 17-21, where the first air gap fiducial and the second air gap fiducial are aligned with the first air gap fiducial nested in the second air gap fiducial.

## Claims

1. A microelectronic component, comprising:
a plurality of layers having a first surface and an opposing second surface, wherein at least one of the plurality of layers includes an active area; and
a fiducial in the active area of the at least one of the plurality of layers, wherein the fiducial includes a geometrically shaped space filled with air.

2. The microelectronic component of claim 1, wherein the at least one of the plurality of layers is at the first surface.

3. The microelectronic component of one of the previous claims, wherein the at least one of the plurality of layers is adjacent to the first surface.

4. The microelectronic component of one of the previous claims, wherein a surface area of the geometrically shaped space filled with air is between 10 microns by 10 microns and 100 microns by 100 microns.

5. The microelectronic component of one of the previous claims, wherein the fiducial is one of a plurality of fiducials.

6. The microelectronic component of claim 5, wherein the plurality of fiducials are arranged in a grid.

7. The microelectronic component of one of the previous claims, wherein the geometrically shaped space filled with air includes a plurality of segments.

8. A microelectronic assembly, comprising:
a first microelectronic component including a first bonding layer with a first air gap fiducial; and
a second microelectronic component including a second bonding layer with a second air gap fiducial, wherein the first microelectronic component is coupled to the second microelectronic component by the first and second bonding layers, and wherein the first air gap fiducial and the second air gap fiducial are aligned.

9. The microelectronic assembly of claim 8, wherein the first air gap fiducial includes a plurality of first air gap segments and the second air gap fiducial includes a plurality of second air gap segments.

10. The microelectronic assembly of claim 8 or 9, wherein the first bonding layer includes a first dielectric material between adjacent ones of first metal contacts, wherein the second bonding layer includes a second dielectric material between adjacent ones of second metal contacts, wherein individual first metal contacts in the first bonding layer are coupled to respective individual second metal contacts in the second bonding layer, and wherein the first metal contacts and the second metal contacts have a pitch equal to or less than 10 microns.

11. A microelectronic assembly, comprising:
a first microelectronic component including a first surface with a first air gap fiducial in an N-1 layer adjacent to an N layer at the first surface; and
a second microelectronic component including a second surface with a second air gap fiducial in an N-1 layer adjacent to an N layer at the second surface, wherein the first microelectronic component is coupled to the second microelectronic component, and wherein the first air gap fiducial and the second air gap fiducial are aligned.

12. The microelectronic assembly of claim 11, further comprising:
a first portion of a comb capacitor including first fingers in the N layer and in the first air gap fiducial in the N-1 layer of the first microelectronic component; and
a second portion of a comb capacitor including second fingers in the N layer and in the second air gap fiducial in the N-1 layer of the second microelectronic component, wherein the first fingers and the second fingers are interdigitated.

13. The microelectronic assembly of any one of the preceding claims, wherein the first air gap fiducial is within an active area of the first microelectronic component and the second air gap fiducial is within an active area of the second microelectronic component.

14. The microelectronic assembly of any one of the preceding claims, wherein the first air gap fiducial is one of a plurality of first air gap fiducials and the second air gap fiducial is one of a plurality of second air gap fiducials.

15. The microelectronic assembly of claim 14, wherein the plurality of first air gap fiducials and the plurality of second air gap fiducials are arranged in a grid.
